# EUROPÄISCHE PATENTSCHRIFT

(11) **EP 1 753 027 B1**
(45) Veröffentlichungstag und Bekanntmachung des Hinweises auf die Patenterteilung: **04.06.2008**
(21) Anmeldenummer: 06016695.6
(22) Anmeldetag: 10.08.2006
(51) Int. Cl.: H01L 23/522

(54) **Monolithische Anordnung, insbesondere integrierte Schaltung, mit einer floatenden Elektrode**
Monolithic assembly, especially integrated circuit, with a floating electrode
Assemblage monolithique, spécialement circuit imprimé, avec une électrode flottante

(30) Priorität: 10.08.2005 DE 102005038100
(43) Veröffentlichungstag der Anmeldung: 14.02.2007
(73) Patentinhaber: Micronas GmbH, 79108 Freiburg (DE)
(72) Erfinder: Wilbertz, Christoph, 79194 Gundelfingen (DE); Frerichs, Heinz-Peter, 79271 St. Peter (DE)
(74) Vertreter: Patentanwälte Westphal, Mussgnug & Partner

(56) Entgegenhaltungen:
- EP-A2- 0 043 014
- EP-A2- 0 181 600
- EP-A2- 1 039 545

## Beschreibung

Die Erfindung bezieht sich auf eine monolithische Anordnung, insbesondere integrierte Schaltung, mit einer floatenden Elektrode gemäß den oberbegrifflichen Merkmalen des Patentanspruchs 1.

Allgemeine bekannt sind monolithische Anordnungen, z.B. auf Glas oder Kunststoff oder Silziumbsubstraten, und integrierte Schaltungen mit einer Vielzahl von potenzialführenden Leiterbahnen zum Übertragen von Signalen oder Strömen zwischen Komponenten, Strukturen und/oder Kontakten der Schaltung, mit einem Messsensor zum Erfassen einer physikalischen Größe, mit zumindest einer Mess-Leiterbahn zum Anschließen des Messsensors an eine Messsystemkomponente und mit einem Isolator zum elektrischen Isolieren der Leiterbahnen. (siehe das Dokument EP-A-1 039 545).

Bei derartigen monolithischen oder integrierten Schaltungen ist aufgrund der planaren Anordnung der Bauelemente eine Vielzahl von Leiterbahnen auf verschiedenen Ebenen notwendig, die durch elektrisch isolierende Schichten als Isolatoren voneinander getrennt sind. Diese Isolationsschichten erlauben prinzipiell auch ein Kreuzen von verschiedenen Leiterbahnen. Die Isolationsschichten werden in der Regel mittels thermischen oder deponierten Si-Oxiden gebildet.

Problematisch wird der Schaltungsaufbau, wenn die integrierte Schaltung sogenannte floatende Elektroden aufweist. Bei floatenden Elektroden handelt es sich um Leiterbahnen, die vollständig von Isolatoren umgeben sind und deren Potential wechseln kann, d.h. floatet. Solche floatenden Elektroden sind z.B. Bestandteil von integrierten Messsensoren, von E²PROMs und EPROMs sowie von CC-FETs.

Bei sich kreuzenden Leiterbahnen können durch Licht oder Wärme im zwischen den Leiterbahnen liegenden Isolator Elektron-Lochpaar erzeugt werden, welche zwischen den benachbarten Leiterbahnen insbesondere bei floatenden Elektroden zu einem ungewollten Ladungsausgleich führen. Bei Anforderungen, bei denen eine sehr hohe Isolation einer Leiterbahn oder Elektrode verlangt wird, führt dies zu Messungenauigkeiten oder Driftproblemen.

Die Aufgabe der Erfindung besteht darin, eine integrierte Schaltung vorzuschlagen, bei der ein derartiger Ladungsausgleich vermieden wird.

Dieser Aufgabe wird durch eine integrierte Schaltung mit den Merkmalen des Patentanspruchs 1.

Vorteilhafte Ausgestaltungen sind Gegenstand der abhängigen Ansprüche.

Bevorzugt wird insbesondere eine monolithische Anordnung oder integrierte Schaltung mit einer floatenden Elektrode, mit zumindest einer Leiterbahn zum Anschließen der floatenden Elektrode an eine Systemkomponente mit einer Vielzahl von zumindest zeitweilig potenzialführenden weiteren Leiterbahnen zum Übertagen von Signalen oder Strömen zwischen Komponentenstrukturen und/oder Kontakten und mit einem Isolator zum elektrischen Isolieren der Leiterbahn und der weiteren Leiterbahnen untereinander, wobei eine Bahnführung der Leiterbahn und der anderen Leiterbahnen derart ausgelegt ist, dass der Verlauf der Leiterbahn den Verlauf keiner der Leiterbahnen kreuzt, wobei der Isolator als Isolationsschicht zwischen der Mess-Leiterbahn und zumindest einer der anderen Leiterbahnen ausgebildet ist. Dabei spielt es keine Rolle, ob die anderen Leiterbahnen auf dieser monolithischen Anordnung oder dieser integrierten Halbleiterschaltung oder einer anderen monolithischen Anordnung oder anderen integrierten Schaltung angeordnet sind oder nicht.

Bei der monolithischen Anordnung kann es sich auch um eine Anordnung handeln, die keine elektronischen aktiven Bauelemente aufweist, sondern lediglich eine floatende Elektrode, die über Bondpads nach außen kontaktiert ist.

Bevorzugt wird insbesondere eine integrierte Schaltung vorgesehen, bei der der Isolator ein Si-Oxid ist.

Bevorzugt wird insbesondere eine Messsensor-Schaltung mit einer solchen integrierten Schaltung mit einem Messsensor.

Bevorzugt wird insbesondere ein Verfahren zum Herstellen einer integrierten Messsensor-Schaltung mit einer floatenden Elektrode, zumindest zeitweilig potenzialführenden Leiterbahnen und zumindest einer weiteren Leiterbahn vorgesehen, wobei die Leiterbahn von zumindest einer weiteren Leiterbahnen mittels eines Isolators elektrisch isoliert beabstandet ist, wobei die Bahnführung der Leiterbahn und der weiteren Leiterbahnen derart ausgelegt wird, dass die Leiterbahn keine der anderen Leiterbahnen kreuzt.

Der Begriff Messsensor ist dabei weit auszulegen und umfasst insbesondere auch eine Messelektrode zum Anschluss eines Messsensors. Die Systemkomponente kann in einem einfachen Fall beispielsweise durch einen ein Messsignal verstärkenden Transistor oder dergleichen ausgebildet werden und muss nicht zwingend eine vollständige Schaltungsanordnung umfassen.

Als Messsensor kann insbesondere auch ein Biosensor Verwendung finden. Mit solchen Biosensoren kann Biomaterial, z.B. menschliche oder tierische Hautzellen, Haarzellen, Nervenzellen, Blutzellen oder dgl. analysiert werden, indem über die floatende Elektrode das Biomaterial platziert wird. Insbesondere mit sog. Neurochipsensoren können lebende Zellen, wie z.B. Nervenzellen, analysiert werden.

Um eventuelle hochohmige licht- und wärmeinduzierte Leckströme zwischen der Leiterbahn, welche z.B. zu einer Messelektrode bzw. dem Messsensor führt, und Leitungen bzw. Leiterbahnen zur Versorgungsspannung, einem Grundpotenzial oder Leiterbahnen als Signalleitungen zu vermeiden, sind Leitungen von einem Messsystem, beispielsweise einem Transistor als der Messsystemkomponente, zu der Messelektrode bzw. dem Messsensor derart ausgeführt, dass sie keine andern potenzialführenden Leiterbahnen kreuzen oder zu sehr in deren Nähe kommen.

Anwendungsmöglichkeiten der Erfindung sind Schaltungsanordnungen mit floatenden, isolierten Leitungen oder Elektroden, wie beispielsweise bei einem EPROM₃ oder EEPROM (Electrically Erasable Programmalbe Read-Only Memory - elektrisch löschbarer programmierbarer Nur-Lese-Speicher) oder kapazitiv gekoppelten Gassensoren (CC-FET) (Capacitive Coupled Field Effekt Transistor).

Ein Ausführungsbeispiel wird nachfolgend anhand der Zeichnung näher erläutert. Es zeigen:
- Fig. 1: eine Draufsicht auf eine beispielhafte integriertes Schaltungsanordnung mit einer Leiterbahn und dazu beabstandet geführten potenzialführenden, weiteren Leiterbahnen und
- Fig. 2: eine Teilschnittansicht durch eine derartige integrierte Schalung mit einem mehrschichtigen Aufbau.

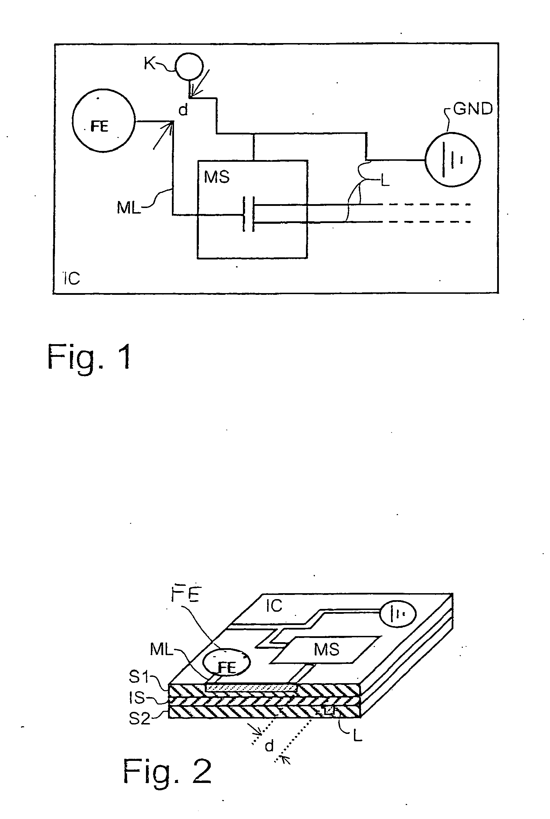

Wie aus Fig. 1 und Fig. 2 ersichtlich ist, besteht eine beispielhafte integrierte Schaltung IC aus vorzugsweise mehreren Schichten S1, S2, welche durch einen Isolator IS in Form einer Isolationsschicht voneinander elektrisch isoliert beabstandet sind. Die integrierte Schaltung IC umfasst typischerweise eine Vielzahl von Komponenten und Strukturen, wie beispielsweise eine floatende Elektrode FE eine Systemkomponente MS in Art einer Auswerteschaltung z.B. für Messsignale des Messsensors ME und einem Grundpotenzial bzw. Erdungsanschluss GND sowie weiteren Komponenten oder Kontakten K zum Anschluss externer Komponenten.

Diese Vielzahl verschiedenartiger Komponenten und Strukturen ist in üblicher Art und Weise durch eine Vielzahl entsprechender Leiterbahnen L untereinander je nach Bedarf verbunden. Insbesondere ist die floatende Elektrode FE mittels einer Leiterbahn ML mit der Systemkomponente MS verbunden, wobei die Systemkomponente MS beispielsweise aus einem ein Messsignal verstärkenden Transistor oder einer komplexen Auswerteschaltung ausgebildet ist.

Die Leiterbahnen L, ML können bei einem mehrschichtigen Aufbau der integrierten Schaltung IC auf die verschiedenen Schichten S1, S2 verteilt angeordnet sein, um auf einfache Art und Weise auch Kreuzungen zwischen einzelnen der Leiterbahnen L zu ermöglichen.

Der Isolator IS wird vorzugsweise durch Si-Oxid oder ein anderes geeignetes Material ausgebildet. Beim Entwurf einer Bahnführung für die Leiterbahn oder mehrere Leiterbahnen ML wird darauf geachtet, dass zu übrigen Leiterbahnen L, welche zumindest zeitweilig potenzialführend sind, eine Mindestabstand d eingehalten wird. Außerdem werden direkte Kreuzungen von der Mess-Leiterbahn ML und weiteren, zeitweilig potenzialführenden Leiterbahnen L vermieden, so dass vorzugsweise in sowohl der Ebene des Verlaufs der Leiterbahn ML als auch in Richtung senkrecht zu dieser Ebene des Verlaufs der Leiterbahn ML ein solcher Mindestabstand d eingehalten wird.

Idealerweise wird somit ein Mindestabstand eingehalten und außerdem ein Vermeiden von Kreuzungen beachtet, wenn der Verlauf der Leiterbahn ML relativ zu den übrigen Leiterbahnen L festgelegt wird.

Um bei einem Verfahren zum Herstellen einer solchen integrierten Schalung IC den Mindestabstand d bestimmen zu können, kann eine Vielzahl empirischer Versuche durchgeführt werden, welche vorteilhafterweise die jeweils verwendeten Materialien des Isolators IS und die maximal auftretenden Potenziale auf den der Mess-Leitung benachbarten Leitungen L berücksichtigen. Vorteilhafterweise ist auch ein rechnerisches Bestimmen des Mindestabstandes d bei Kenntnis dieser entsprechenden physikalischen Parameter möglich. Um eine optimale Reduzierung des Flächenbedarfs der integrierten Schaltung IC zu ermöglichen, wird der Mindestabstand d als ein Minimalabstand berechnet, um eine zu große Beabstandung von mehr als dem 1,5-fachen oder insbesondere 2-fachen des Mindestabstandes d zu weiteren Leiterbahnen L zu vermeiden.

## Patentansprüche

1. Monolithische Anordnung (IC) mit
- einer floatenden Elektrode (FE),
- zumindest einer Leiterbahn (ML) zum Anschließen der floatenden Elektrode (FE) an eine Systemkomponente (MS) innerhalb der monolithischen Anordnung,
- einer Vielzahl von zumindest zeitweilig potenzialführenden, weiteren Leiterbahnen (L) zum Übertagen von Signalen oder Strömen zwischen Komponenten (MS, GND), Strukturen und/oder Kontakten (K), und
- einem Isolator (IS) zum elektrischen Isolieren der Leiterbahn (ML) und den weiteren Leiterbahnen (L) untereinander,
**dadurch gekennzeichnet, dass**
- eine Bahnführung der Leiterbahn (ML) und der weiteren Leiterbahnen (L) derart ausgelegt ist, dass der Verlauf der Leiterbahn (ML) den Verlauf keiner der weiteren Leiterbahnen (L) kreuzt, der Isolator (IS) als Isolationsschicht zwischen der Leiterbahn (ML) und zumindest einer der weiteren Leiterbahnen (L) ausgebildet ist, wobei die Leiterbahn (ML) und wenigstens eine der weiteren Leiterbahnen (L) in unterschiedlichen Ebenen der monolithischen Anordnung ausgebildet sind.

2. Monolithische Anordnung nach Anspruch 1,
**dadurch gekennzeichnet, dass** der Isolator (IS) ein Si-Oxid ist.

3. Monolithische Anordnung nach einem der Ansprüche 1 oder 2,
**dadurch gekennzeichnet, dass** die floatende Elektrode (FE) Bestandteil eines Messsensors, insbesondere eines Biosensors, ist.

4. Monolithische Anordnung nach einem der Ansprüche 1 oder 2,
**dadurch gekennzeichnet, dass** die floatende Elektrode Bestandteil eines E² PROM, EPROM oder ein CC-FET ist.

5. Monolithische Anordnung nach einem der Ansprüche 1 bis 4,
**dadurch gekennzeichnet, dass** diese monolithische Anrodung eine integrierte Halbleiterschaltung ist.

6. Messsensor-Schaltung mit einer monolithischen Anordnung nach einem der Ansprüche 1 bis 4 oder einer integrierten Halbleiterschaltung nach Anspruch 5.

## Claims

1. A monolithic configuration (IC) comprising:
- a floating electrode (FE);
- at least one conductor track (ML) for connecting the floating electrode (FE) to a system component (MS) inside the monolithic configuration;
- a plurality of other conductor tracks (L) at least temporarily conducting potential in order to transmit signals or currents between components (MS, GND), structures and/or contacts (K); and
- an insulator (IS) for electrically insulating the conductor track (ML) and the other conductor tracks (L) from each other,
**characterised in that**
- the routing of the conductor track (ML) and of the other conductor tracks (L) is designed such that the path of the conductor track (ML) does not cross the path of any of the other conductor tracks (L), the insulator (IS) is configured as an insulation layer between the conductor track (ML) and at least one of the other conductor tracks (L), with the conductor track (ML) and at least one of the other conductor tracks (L) being constructed in different planes of the monolithic configuration.

2. A monolithic configuration according to Claim 1,
**characterised in that** the insulator (IS) is a silicon oxide.

3. A monolithic configuration according to one of Claims 1 or 2,
**characterised in that** the floating electrode (FE) is a component of a measuring sensor, in particular a biosensor.

4. A monolithic configuration according to one of Claims 1 or 2,
**characterised in that** the floating electrode is component of an E²PROM, EPROM or a CC-FET.

5. A monolithic configuration according to one of Claims 1 to 4,
**characterised in that** this monolithic configuration is an integrated semiconductor circuit.

6. A measuring sensor circuit having a monolithic configuration according to one of Claims 1 to 4, or an integrated semiconductor circuit according to Claim 5.

## Revendications

1. Circuit monolithique (IC) comportant
- une électrode flottante (FE),
- au moins un chemin conducteur (ML) pour brancher l'électrode flottante (FE) sur un composant de système (MS) dans le circuit monolithique,
- un ensemble d'autres chemins conducteurs (L) conduisant au moins de temps en temps un potentiel, pour transmettre des signaux ou des courants entre les composants (MS, GND), les structures et/ou les contacts (K), et
- un isolant (IS) pour isoler électriquement le chemin conducteur (ML) et les autres chemins conducteurs (L) les uns des autres,
**caractérisé en ce que**
le tracé du chemin conducteur (ML) et des autres chemins conducteurs (L) est réalisé pour que le tracé du chemin conducteur (ML) ne coupe le tracé d'aucun autre des chemins conducteurs (L), l'isolant (IS) est réalisé comme couche d'isolation entre les chemins conducteurs (ML) et au moins l'un des autres chemins conducteurs (L),
le chemin conducteur (ML) et au moins l'un des autres chemins conducteurs (L) étant réalisés dans des plans différents du circuit monolithique.

2. Circuit monolithique selon la revendication 1,
**caractérisé en ce que**
l'isolant (IS) est un oxyde de silicium.

3. Circuit monolithique selon l'une des revendications 1 ou 2,
**caractérisé en ce que**
l'électrode flottante (FE) fait partie d'un capteur de mesure, notamment d'un biocapteur.

4. Circuit monolithique selon l'une des revendications 1 ou 2,
**caractérisé en ce que**
l'électrode flottante fait partie d'un E²PROM, EPROM ou d'un CC-FET.

5. Circuit monolithique selon l'une des revendications 1 à 4,
**caractérisé en ce que**
ce circuit monolithique est un circuit intégré semi-conducteur.

6. Montage de capteur de mesure comportant un circuit monolithique selon l'une des revendications 1 à 4 ou un circuit semi-conducteur intégré selon la revendication 5.
